# EUROPEAN PATENT SPECIFICATION

(11) **EP 4 415 032 B1**
(45) Date of publication and mention of the grant of the patent: **29.07.2026**
(21) Application number: 23825355.3
(22) Date of filing: 31.10.2023
(51) Int. Cl.: H10W 40/22, H10W 70/60, H10W 70/63, H10W 70/685, H10W 74/01, H10W 74/10, H10W 90/00

(54) **FAN-OUT PACKAGING METHOD, FAN-OUT PACKAGING STRUCTURE, AND MANUFACTURING METHOD THEREFOR**
AUFFÄCHERUNGSVERPACKUNGSVERFAHREN, AUFFÄCHERUNGSVERPACKUNGSSTRUKTUR UND HERSTELLUNGSVERFAHREN DAFÜR
PROCÉDÉ D'ENCAPSULATION AVEC ÉVENTAIL DE SORTIE, STRUCTURE D'ENCAPSULATION AVEC ÉVENTAIL DE SORTIE, ET PROCÉDÉ DE FABRICATION CORRESPONDANT

(30) Priority: 19.12.2022 CN 202211636697
(43) Date of publication of application: 14.08.2024
(73) Proprietor: Hygon Information Technology Co., Ltd., Tianjin 300392 (CN)
(72) Inventor: CHEN, Bochang, Tianjin 300392 (CN)
(74) Representative: Regimbeau
(86) International application number: PCT/CN2023/128505
(87) International publication number: WO 2024/131304

(56) References cited:
- WO-A1-2013/070806
- CN-A- 115 020 373
- CN-A- 116 072 554
- US-A1- 2020 176 346
- US-A1- 2020 176 346
- US-A1- 2021 125 905
- US-A1- 2021 366 789
- US-A1- 2022 301 970

## Description

This application is based on International Patent Application No. PCT/CN2023/128505, filed on October 31, 2023, which claims the priority to and benefits of Chinese Patent Application No. 202211636697.2, filed on December 19, 2022.

### TECHNICAL FIELD

Embodiments of the present disclosure relate to the field of chip packaging technology, and in particular to a fan-out packaging method, a fan-out package structure and manufacturing method hereof.

### BACKGROUND

During the packaging of a high-end chip, because the chip has a high degree of integration, which results in that the quantity of substrate layer is too high, and fan-out packaging cannot completely replace the substrate; thus, if a fan-out is to be used during the packaging of high-end chip, a chip-level fan-out package shall first be accomplished necessarily, then the fan out chip assembled with substrate by flip-chip. This process contains a fan-out wafer level process, flip-chip process, and the whole process is very complicated, and it needs to consider the overall shrinkage data of the fan-out chip, to prevent the fan out chip from being misaligned when assembled on the substrate. In addition, the substrate warpage during assembly will cause the risk of the whole packaging process to be higher. US2022301970A1 discloses a semiconductor package and a method of manufacturing semiconductor package. US2020176346A1 discloses semiconductor packages and methods of manufacturing the same. WO2013070806A1 discloses voltage switchable dielectric material formations and supporting impedance elements for ESD protection. US2021366789A1 discloses precision thin electronics handling integration.

### SUMMARY

The invention is defined by the features of independent claims. Preferred embodiments are set out in the dependent claims.

### BRIEF DESCRIPTION OF THE DRAWINGS

FIG. 1 is a flowchart of a fan-out packaging method of one embodiment of the present invention;
FIG. 2 is a structure of a package substrate of another embodiment of the fan-out packaging method of the present invention;
FIG. 3 is a structure after bonding a rigid carrier plate of another embodiment of the fan-out packaging method of the present invention;
FIG. 4 is a structure after disposing an RDL structure of another embodiment of the fan-out packaging method of the present invention;
FIG. 5 is a structure after disposing a passive device of another embodiment of the fan-out packaging method of the present invention;
FIG. 6 is a structure after disposing a chip of another embodiment of the fan-out packaging method of the present invention;
FIG. 7 is a structure of arranging chips of another embodiment of the fan-out packaging method of the present invention;
FIG. 8 is a structure after underfill and molding of another embodiment of the fan-out packaging method of the present invention;
FIG. 9 is a structure of exposing a backside of a chip of another embodiment of the fan-out packaging method of the present invention;
FIG. 10 is a structure forming a heat sink metal layer of another embodiment of the fan-out packaging method of the present invention;
FIG. 11 is a structure after the debonding of another embodiment of the fan-out packaging method of the present invention;
FIG. 12 is a structure after sawing of another embodiment of the fan-out packaging method of the present invention;
FIG. 13 is a structure after mounting a heat sink cover of another embodiment of the fan-out packaging method of the present invention;
FIG. 14 is a structure after disposing a passive device of another embodiment of the fan-out packaging method of the present invention;
FIG. 15 is the structure after disposing a chip of another embodiment of the fan-out packaging method of the present invention;
FIG. 16 is a structure after disposing a heat sink metal layer of another embodiment of the fan-out packaging method of the present invention;
FIG. 17 is the structure after disposing a heat sink back cover of another embodiment of the fan-out packaging method of the present invention.

### DETAILED DESCRIPTION

In order to make the objects, technical solutions and advantages of the embodiments of the present invention clearer, the technical solutions in the embodiments of the present invention will be clearly and completely described below in conjunction with the accompanying drawings in the embodiments of the present invention, and it is clear that the described embodiments are only a part of the embodiments of the present invention, but not all of the embodiments. Based on the embodiments in the present invention, all other embodiments obtained by a person of ordinary skill in the art without making creative labor are within the scope of protection of the present invention.

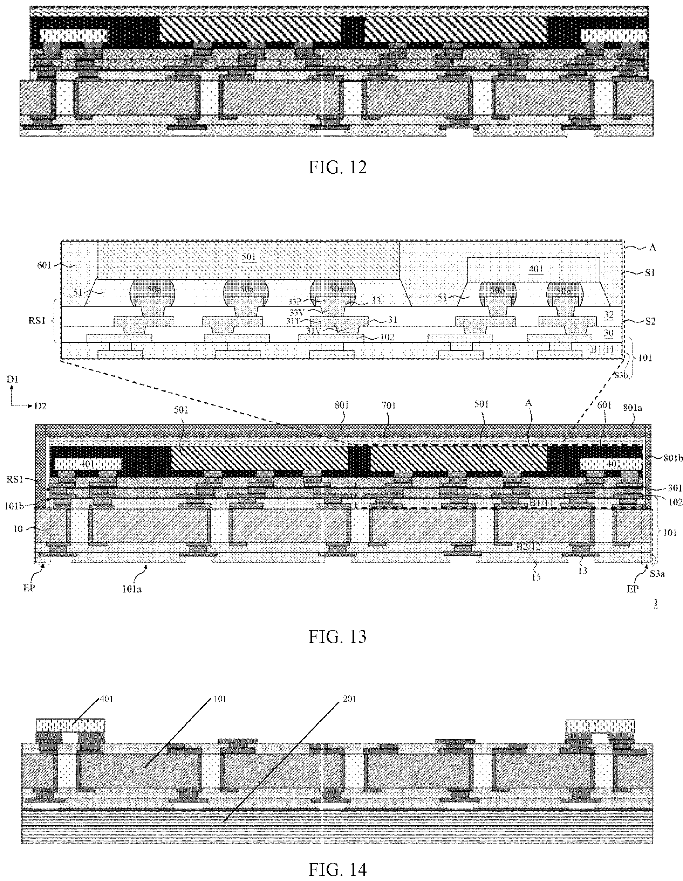

FIG. 13 illustrates a schematic cross-sectional view of a package structure according to some embodiments of the present disclosure and a schematic enlarged view of area A in the package structure.

Referring to FIG. 13, in some embodiments, package structure 1 is a fan-out package structure, and may comprise a package substrate 101, an RDL structure RS1 and a chip 501. The package substrate 101 has a first side 101a and a second side 101b opposite to each other in a first direction D1 and has a first conductive layer 102 disposed on the second side 101b. The RDL structure RS1 is disposed on the second side 101b of the package substrate 101 and includes at least one dielectric layer and at least one RDL layer 301. The at least one RDL layer 301 is embedded in the at least one dielectric layer and electrically connected to the first conductive layer 102. A chip 501 is disposed on a side of the RDL structure RS1 away from encapsulation layer 101 and electrically connected to the at least one RDL layer 301 of the RDL structure RS1.

For example, the at least one dielectric layer may comprise dielectric layer 30 and dielectric layer 32, the at least one RDL layer may comprise RDL layer 31 and RDL layer 33. The dielectric layer 30 is disposed on the second side 101b of the package substrate 101, and covers the first conductive layer 102, e.g., may cover and contact a sidewall of the first conductive layer 102 and a portion of a surface of a side thereof close to the RDL structure RS1. The RDL layer 31 extends through the dielectric layer 30 to be in contact with and electrically connected with the first conductive layer 102 of the package substrate 101, i.e., the RDL layer 31 and the first conductive layer 102 are directly connected. The RDL layer 33 extends through the dielectric layer 32 to be electrically connected with the RDL layer 31. In some embodiments, the dielectric layer 30 and the dielectric layer 32 may be referred to as a first dielectric layer and a second dielectric layer, respectively, and the RDL layer 31 and the RDL layer 33 may be referred to as a first RDL layer and a second RDL layer, respectively, wherein the first dielectric layer and the first RDL layer are, respectively, a dielectric layer and an RDL layer of the at least one dielectric layer and the at least one RDL layer closest to the encapsulation layer 101, and may contact with the package substrate 101. It should be understood that a number of layers of the dielectric layer and the RDL layer included in the RDL structure described in the drawings is only for illustration, and this disclosure is not limited to this, and the number of layers of the dielectric layer and the RDL layer can be adjusted according to product design and requirements.

Herein, "contacting" a corresponding member of an RDL structure with a corresponding member of a package substrate means that, the members are "directly in contact" and the term "connected directly" means that the members are in contact directly with and be connected (e.g., electrically connected) to each other without the need for connection through other intermediate members. That is, in this embodiment of the present disclosure, the RDL layer 31 of the at least one RDL layer 101 of the RDL structure RS1 that is closest to the package substrate 101 is directly connected with the first conductive layer 102 of the package substrate 101 without the need for other intermediate members (e.g., intermediate connectors, such as solder balls) to realize the electrical connection between the RDL layer 31 and the first conductive layer 102.

In some embodiments, the RDL layer 31 may comprise a conductive via 31V and a conductive trace 31T, the conductive via 31V is located between the conductive trace 31T and the first conductive layer 102 of the package substrate 101, and electrically connects the conductive trace 31T to the first conductive layer 102. For example, the conductive via 31V may be embedded in and through the dielectric layer 30 to connect with the first conductive layer 102, and the conductive trace 31T is located on a side of the dielectric layer 30 away from the package substrate 101. In some embodiments, the conductive via 31V and the conductive trace 31T may be formed in the same patterning process and there may not be a visible interface between them, but the present disclosure is not limited thereto.

The conductive via 31V laps over the first conductive layer 102 and connects directly with the first conductive layer 102; for example, a sidewall of the first conductive layer 102 and a portion of a surface of a side thereof close to the RDL structure RS1 is covered by and in contact with the dielectric layer 30, and another portion of the surface of a side of the first conductive layer 102 close to the RDL structure RS1 being in contact with the conductive via 31V. In some embodiments, a cross-sectional shape of the conductive via 31V may be a square shape (such as a square, or a rectangle), or may also be a trapezoidal shape (such as an inverted trapezoid). In some examples, the conductive via 31V may be in an inverted trapezoidal shape and a width of the conductive via 31V may taper as it moves closer to the package substrate 101; for example, the conductive via 31V has a first width and a second width; the first width is a width of a side of the conductive via 31V close to the conductive layer 102, which for example, may also be referred to as a bottom width; the second width is a width of a side of the conductive via 31T away from the conductive layer 102 (i.e., close to the conductive trace 31T), which for example may also be referred to as a top width; both the first width and the second width are widths in a direction parallel to a main surface of the package substrate (e.g., a second direction D2). In some examples, the first width may be less than the second width, but the present disclosure is not limited thereto.

With continuing reference to FIG. 13, the dielectric layer 32 is disposed in the dielectric layer 30 and covers a sidewall of the conductive trace 31T and a portion of a surface of a side thereof away from the conductive via 31V. In some examples, the RDL layer 33 is a top RDL layer 33 of a plurality of RDL layers that is closest to the chip 501 as shown in the enlarged figure, and may include at least the conductive via 33V. The conductive via 33V is embedded in the dielectric layer 32 and passes through the dielectric layer 32 to connect with the conductive trace 31T of the RDL layer 31. In some embodiments, the RDL layer 33 may also comprise a conductive pad 33P, and the conductive pad 33P electrically connects to the RDL layer 31 through the conductive via 33V. The conductive pad 33P may protrude in a direction perpendicular to the main surface of the package substrate (e.g., the first direction D1) from a surface of a side of the dielectric layer 32 away from the package substrate; e.g., the conductive pad 33P may be disposed on a surface of a side of the dielectric layer 32 away from the package substrate, and is used for electrically connecting with other members such as chips, passive devices, and the like. The width of the conductive pad 33P may be larger than a width of the conductive via 33V to facilitate engaging with other members. In some embodiments, the conductive pad 33P may also be omitted, and the members (such as chips, passive devices, and the like) located on a side of the RDL structure away from the package substrate may be engaged to the conductive via 33V; i.e., the conductive via 33V may also be used as a conductive pad.

In some embodiments, the package structure 1 may also include an underfill layer 51 and an encapsulation layer 601. Both the underfill layer 51 and the encapsulation layer 601 are disposed on a side of the RDL structure RS1 away from the package substrate 101, and surround and encircle the chip 501 to provide protection for the chip 501. For example, one or more of the chips 501 may each be electrically connected to the RDL structure RS1 via an electrically conductive connector 50a. An electrically conductive connector 50a may be disposed between conductive member (e.g., conductive pad and/or conductive post, etc.) of chip 501 and the conductive pad 33P of the RDL structure, to realize the chip 501 electrically connecting to the RDL layer in the RDL structure. The underfill layer 51 may be disposed between chip 501 and the RDL structure in a first direction D1 perpendicular to the main surface of the package substrate; for example, there is a gap between chip 501 and the RDL structure RS1, and the underfill layer 51 fills the gap and may surround the conductive connector 50a in a direction parallel to the main surface of the package substrate (e.g., in a horizontal direction including the second direction D2).

The encapsulation layer 601 may surround and enclose chip 501 at least in a direction parallel to the main surface of the package substrate (e.g., horizontally in the second direction D2) and may cover a sidewall of the underfill layer 51. In some embodiments, the encapsulation layer 601 may be a molding layer and may, for example, include a molding material such as an epoxy molding compound (EMC), but the present disclosure is not limited thereto.

With continuing reference to FIG. 13, in some embodiments, the package structure 1 may also include one or more passive devices 401. For example, the passive device 401 may be disposed on a side of the RDL structure RS1 away from the package substrate 101 and electrically connected to the RDL structure RS1. In some embodiments, the passive device 401 may be electrically connected to a corresponding conductive pad 33P in a top RDL layer of the RDL structure RS1 via electrically conductive connectors 50b (such as solder balls, micro bumps, etc.). An underfill layer 51 may also be disposed between the passive device 401 and the RDL structure RS1 to fill the gap between the passive device 401 and the RDL structure RS1, and the underfill layer surrounds and encircles the conductive connector 50b in a direction parallel to the main surface of the package substrate. The encapsulation layer 601 may also enclose the passive device 401 and may cover a sidewall of the underfill layer located between the passive device and the RDL structure. For example, the encapsulation layer 601 may surround and enclose the passive device 401 in a direction parallel to the main surface of the package substrate and may also cover a surface of the passive device 401 on a side away from the RDL structure RS1. That is, the passive device 401 may be embedded throughout the underfill layer and the encapsulation layer 601. In some embodiments, such passive device 401 disposed on a side of the RDL structure away from the package substrate is referred to as a first passive device.

In this example, one or more chips 501 and one or more passive devices 401 may both be disposed on a side of the RDL structure RS1 away from the package substrate 101 and enclosed in the encapsulation layer 601. The one or more chips 501 and the one or more passive devices 401 may electrically connect to each other via an RDL layer in the RDL structure RS1 and/or a conductive line in the package substrate 101, but the present disclosure is not limited thereto. The chip 501 and the passive device 401 may be disposed side-by-side in a direction parallel to the main surface of the package substrate (e.g., a horizontal direction such as the second direction D2). In some embodiments, the underfill layer 51 disposed between different chips and/or passive devices and the RDL structure may be spaced apart from each other or may also be connected to each other, and the present disclosure is not limited thereto.

Chip 501 and passive device 401 may have same or different heights; for example, a height of chip 501 may be greater than a height of passive device 401; i.e., a distance between a surface of a side of chip 501 away from the package substrate and a surface (e.g., the upper surface of the dielectric layer 32) of a side of the RDL structure away from the package substrate is greater than a distance between a surface of a side of the passive device 401 away from the package structure and the surface of the RDL structure. In some embodiments, a surface of a side of the encapsulation layer 601 away from the package substrate may be substantially flush with the surface of a side of the chip 501 away from the package substrate in a direction parallel to the main surface of the package substrate (e.g., in a horizontal direction such as the second direction D2), but the present disclosure is not limited thereto.

In some embodiments, a sidewall S1 of the encapsulation layer 601 may be substantially aligned with a sidewall S2 of the RDL structure in a first direction D1 perpendicular to the main surface of the package substrate, and the package substrate 101 has an extension EP, wherein the extension EP protrudes, in a direction parallel to the main surface of the package substrate 101, from (i.e., extends beyond) the sidewall S1 of the encapsulation layer 601 and the sidewall S2 of the RDL structure RS1. That is, a width of the package substrate 101 in a direction parallel to the main surface of the package substrate (e.g., the second direction D2) may be greater than a width of the RDL structure RS1 and the encapsulation layer 601 in the direction.

In some embodiments, the package structure 1 may further include a heat sink member 801, and the heat sink member 801 may be disposed on the extension EP of the package substrate 101 and affixed to a surface of a side of the chip 501 away from the RDL structure RS1. For example, package structure 1 may further comprise a heat sink layer 701, wherein the heat sink layer 701 is disposed on a surface of a side of chip 501 away from the RDL structure RS1 and located between the chip 501 and the heat sink member 801, and the heat sink member 801 may be adhered to the surface of a side of the chip 501 away from the RDL structure RS1 through the heat sink layer 701. In some embodiments, the heat dissipation member 801 may be a heat sink cover or any other type of heat sink apparatus, and the present disclosure does not limit the type of heat sink member. The heat sink layer 701 may be or include a layer of material that helps sink heat from the chip (such as a heat sink metal layer, a layer of thermal interface material), and the present disclosure does not impose a limitation on the type of material of the heat sink layer.

For example, the heat sink member 801 may include a main body portion 801a and an additional portion 801b connected to each other. the main body portion 801a is disposed on a side of chip 501 away from the RDL structure RS1 and may extend in a direction parallel to the main surface of the package substrate and be affixed to the chip 501 by the heat sink layer 701. The additional portion 801b is disposed on the extension EP of the package substrate 101 and may surround the RDL structure and the encapsulation layer 601 in a direction parallel to the main surface of the package substrate. For example, the additional portion 801b may be affixed to the package substrate by an adhesion layer.

With continuing reference to FIG. 13, in some embodiments, the package substrate 101 may be a line substrate and may include a plurality of conductive lines. For example, the package substrate 101 may include a core layer 10 and a build-up layer B1 and a build-up layer B2 disposed on opposite sides of the core layer 10 in the first direction D1. For example, the build-up layer B1 and the build-up layer B2 may be disposed on a second side 101b and a first side 101a, respectively, of the package substrate 101. The core layer 10 may include a core dielectric layer and a conductive structure, wherein the conductive structure includes, for example, a conductive via extending through the core dielectric layer, or may also include a conductive wire and/or a conductive pad and the like, disposed in the first direction D1 on opposite sides of the core dielectric layer and connected to the conductive via.

The build-up layer B1 and the build-up layer B2 may each include one or more dielectric layers and conductive layers. The conductive layers may include conductive vias, electrically conductive wires and/or conductive pads, etc., connected to each other and electrically connected to electrically conductive structures in the core layer. For example, the build-up layer B1 comprises a dielectric layer 11 and a first conductive layer 102, at least a portion of the first conductive layer 102 may be exposed from the dielectric layer 11 for electrical connection to the RDL structure. For example, at least a portion of the first conductive layer 102 is located on a side of the dielectric layer 11 away from the core layer 101 and the at least a portion of the first conductive layer 102 may be embedded in the dielectric layer 30 of the RDL structure RS1 and contacted and electrically connected to the RDL layer 31.

In some embodiments, the build-up layer B2 may comprise a dielectric layer 12 and a second conductive layer 13, at least a portion of the second conductive layer 13 may be located on a side of the dielectric layer away from the core layer. In some embodiments, the package substrate 101 may also comprise a solder mask 15 disposed on the first side 101a thereof, and the solder mask 15 may cover at least a portion of the second conductive layer 13, for example, may cover a sidewall of the second conductive layer 13 and a portion of a surface of a side thereof away from the RDL structure. Another portion of the surface of a side of the second conductive layer 13 away from the RDL structure may be exposed from the solder mask 15, to be used in the further electrical connection, but the present disclosure is not limited thereto.

In embodiments of the present disclosure, since the RDL structure RS1 is directly disposed on the second side 101b of the package substrate 101, and the first conductive layer 102 located on the second side of the package substrate 101 can be directly covered by the dielectric layer of the RDL structure RS1 and electrically connected with the corresponding RDL; thus, the solder mask may be not required to dispose on the second layer 101b of the package substrate 101. That is, the package substrate 101 has the solder mask 15 on a side away from the RDL structure RS1 (i.e., the first side 101a) and may not have solder mask 15 on a side close to the RDL structure RS1 (i.e., the second side 101b).

In some embodiments, as shown in FIG. 13, the extension EP of the package substrate 101 may comprise the core layer 10 and the dielectric layer in the build-up layer B2 as well as an edge portion of the solder mask, and may not comprise the build-up layer B1. For example, an additional portion 801b of the heat sink member 801 may lap on a dielectric layer of the core layer 10. The package substrate 101 may have a sidewall S3a and a sidewall S3b, the sidewall S3a may be a sidewall of the extension EP and the sidewall S3b may be a sidewall of the build-up layer B1. In some embodiments, the sidewall S3a and the sidewall S3b of the package substrate 101 may be offset apart in a direction parallel to the main surface of the package substrate, i.e., the sidewall S3a and the sidewall S3b are not aligned in a first direction D1 perpendicular to the main surface of the package substrate. In some embodiments, the sidewall S3b of the package substrate 101 may be substantially aligned with the sidewall S2 of the RDL structure RS1 and the sidewall S1 of the encapsulation layer 601 in the first direction D1. However, the present disclosure is not limited thereto.

In some embodiments, the sidewalls of the package substrate and the RDL structure may be both corresponding sidewalls of dielectric materials, and sidewalls of the conductive member in the package substrate and the RDL structure are both covered and protected by corresponding dielectric materials, without being exposed at an edge or a sidewall of the entire structure (e.g., as shown in the enlarged figure).

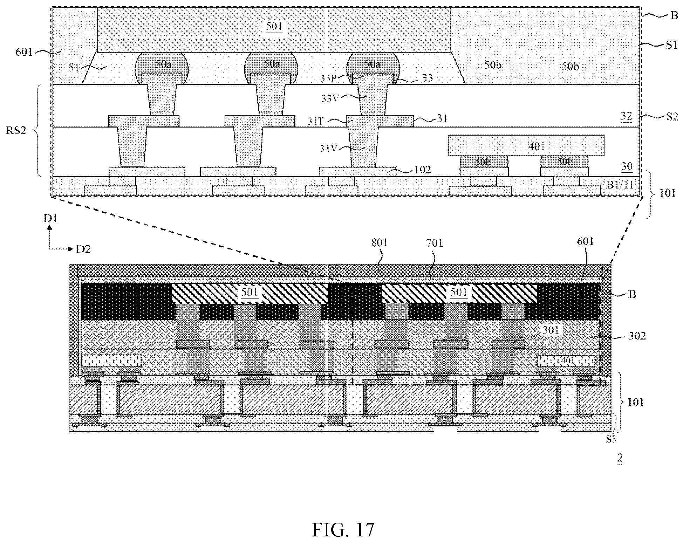

FIG. 17 illustrates a schematic cross-sectional view of a package structure and a schematic enlarged view of area B in the package structure, according to some other embodiments of the present disclosure. The package structure of the present embodiment is similar to the embodiment described previously, the difference is that the package structure comprises a passive device disposed in at least one dielectric layer of the RDL structure, and the passive device is electrically connected to the conductive layer of the package substrate. Such a passive device embedded in the RDL structure may be referred to a second passive device.

Referring to FIG. 17, in some embodiments, a package structure 2 may comprise an RDL structure RS2 and one or more passive devices 401; the RDL structure RS2 may comprise at least one RDL layer 301 and at least one dielectric layer 302. For example, similar to the embodiments described previously, at least one RDL layer 301 may comprise an RDL layer 31 and an RDL layer 33, and at least one dielectric layer 302 may comprise a dielectric layer 30 and a dielectric layer 32. In some embodiments, one or more passive devices 302 are embedded in the dielectric layer 30; for example, the passive device 401 may be engaged to a first conductive layer 102 of the package substrate 101 through a conductive connector 50b, and electrically connected to the first conductive layer 102. The dielectric layer 30 may surround and encircle the passive device 401, for example, may cover a sidewall of the passive device 401 and a portion of a surface of a side thereof away from the package substrate 101; the dielectric layer 30 may also be located in a gap between the passive device 401 and the package substrate 101, covering a surface of the passive device 401 close to the package substrate 101 and surrounding a conductive connector 50b. In an alternative embodiment, an underfill layer may be disposed between the passive device 401 and the package substrate 101 (not shown), to fill the gap between the passive device 401 and the package substrate 101, surround and encircle the conductive connector 50b, and a sidewall of the underfill layer may be covered by the dielectric layer 30. It is understood that a location of the passive device 401 shown in the drawings is for illustration only and the present disclosure is not limited thereto, and the passive device may be embedded at any suitable location in the RDL structure depending on the product design and requirements. For example, in some other examples, the passive device may also be embedded in the dielectric layer 32 and may be connected to the RDL layer 31.

In this embodiment, no passive device is disposed on a side of the RDL structure RS2 away from the package substrate 101, but the present disclosure is not limited thereto. In some other embodiments, the package structure may include a passive device embedded in the RDL structure, and include a passive device provided on a side of the RDL structure away from the package substrate. That is, the package structure may include at least one of the first passive device and the second passive device. The quantity of passive devices shown in the drawings is for illustration only, and the present disclosure is not limited thereto.

Other structural features of package structure 2 are similar to those described for package structure 1 in the preceding embodiments and will not be repeated herein.

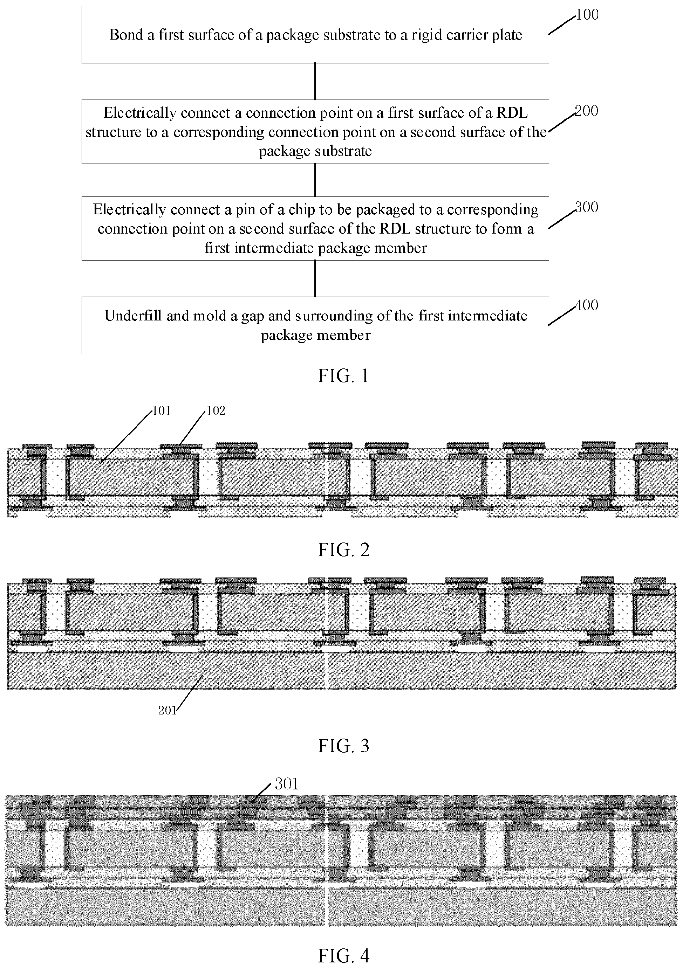

The embodiments of the present invention provide a fan-out packaging method (i.e., a manufacturing method of fan-out package structure), as shown in FIG. 1, the method comprises:
Step 100: bonding a first surface of a package substrate to a rigid carrier plate;
   In some embodiments, the package substrate has a first side and a second side opposite to each other in a first direction, and the package substrate has two surfaces, wherein one surface is a surface connected to the RDL structure, and another surface is a surface exposed outside after completing the packaging. In the embodiment, a first surface and a second surface are located on a first side and a second side, and the first surface is the surface exposed outside after completing the packaging. Bonding the package substrate to the rigid carrier plate refers to connecting the package substrate by ways of gluing, etc., and the connection way should be able to be disassembled after completing the packaging. The rigid carrier plate can effectively provide rigid support for the package substrate to avoid warping or shrinkage during the packaging.
Step 200: electrically connecting a connection point on a first surface of an RDL structure to a corresponding connection point on a second surface of the package substrate;
   In some embodiments, the RDL structure is a packaged device having multiple metal wires, and the RDL structure has two surfaces, one of which has a connection point corresponding to a connection point on the package substrate, and another surface has a connection point corresponding to connector (e.g., a conductive pad, a conductive post, pin, etc.) on a chip to be packaged. The RDL structure is used to form an electrical connection between the chip to be packaged and the package substrate.

In some embodiments, the connection point on the first surface of the RDL structure may comprise an RDL layer disposed on a side of the RDL structure close to the package substrate, and the corresponding connection point of the second surface of the package substrate may comprise a first conductive layer disposed on the second side of the package substrate. The electrically connecting the connection point on a first surface of an RDL structure to the corresponding connection point on a second surface of the package substrate may comprise: forming an RDL structure on the second side of the package substrate, the RDL structure comprising at least one dielectric layer and at least one RDL layer, the at least one RDL layer being embedded in the at least one dielectric layer and electrically connected to the first conductive layer, the at least one dielectric layer and the at least one RDL layer comprise a first dielectric layer and a first RDL layer, respectively, and the first RDL layer passes through the first dielectric layer to be in contact with and electrically connected to the first conductive layer of the package substrate. That is, the RDL structure may be formed directly on the package substrate without being connected to the package substrate through other intermediate members.

Step 300: electrically connecting a pin of a chip to be packaged to a corresponding connection point on a second surface of the RDL structure to form a first intermediate package member;
In some embodiments, after being electrically connecting the pin of the chip to be packaged to a second surface of the RDL structure, the pins of the chip to be packaged are electrically connected to the package substrate through the RDL structure, thereby capable of combining with other devices through the package substrate. In some embodiments, the chip may be engaged to the RDL structure through conductive connectors.

Step 400: underfill and molding a gap and surrounding of the first intermediate package member. As used herein, the terms "underfill" and "underfilling" refer to an "underfilling process". In some embodiments, underfill and molding the gap and surrounding of the first intermediate package member comprises: performing an underfilling process to form an underfill layer between the chip and the RDL structure; and performing an encapsulation process to form an encapsulation layer on a side of the RDL structure away from the package substrate. The encapsulation process may for example comprise a molding process, and the encapsulation layer may comprise a molding layer.

In some embodiments, during underfill and molding, the gaps between the plurality of chips and the surroundings of the plurality of chips are backfilled and molded with an insulating material, thereby forming a fixing and protecting effect on the chips.

The technical solution provided by the present invention, by bonding the substrate to the rigid carrier plate and directly forming the RDL structure on the substrate, can effectively prevent alignment errors caused by warping and shrinkage and other factors during the packaging, avoiding the occurrence of the risk of circuit breakage due to alignment errors. At the same time, the technical solution provided by the present invention combines fanning-out package body and substrate interconnecting processes, and packages the substrate bonded to the rigid carrier plate layer by layer with the RDL structure and the chip, which can realize the fact of simplifying the process steps of interconnecting the fan-out package body and the substrate.

As one optional implementation, before the step of electrically connecting a connection point on a first surface of an RDL structure to a corresponding connection point on a second surface of the package substrate, further comprising:
disposing a passive device on the package substrate such that the passive device forms an electrical connection with the package substrate. For example, the passive device may be engaged to a first conductive layer of the package substrate, and a subsequent-formed dielectric layer of the RDL construction may cover the passive device.

In some embodiments, the passive device refers to a passive element such as a capacitor, an inductor, and a resistor. During the packaging, if a passive device is required to be matched, the connection point for connecting the passive device may be reserved on the package substrate, and the passive device may be disposed on the package substrate, after bonding the package substrate to the rigid carrier plate.

As one optional implementation, after the step of electrically connecting a connection point on a first surface of an RDL structure to a corresponding connection point on a second surface of the package substrate, further comprising: disposing a passive device on the RDL structure such that the passive device forms an electrical connection with the RDL structure. For example, after the RDL structure has been formed on the package substrate, the passive device may be engaged to the RDL structure, such that the passive device is electrically connected to at least one RDL layer in the RDL structure.

In some embodiments, during the packaging, if a passive device is required to be matched, the connection point for connecting the passive device also can be reserved on the RDL structure, and the passive device can be connected to the RDL structure after the RDL structure is electrically connected with the package substrate.

In the above two implementations, one is to dispose the passive device on the RDL structure, and this method for packaging may effectively reduce the overall packaging thickness, which is due to the fact that the passive device occupies the same layer with the chip, and does not need to occupy extra thickness space; and the passive device can be encircled by a subsequent-formed underfill layer and encapsulation layer, thereby being protected. Another one is to dispose the passive device on the package substrate, and this method for packaging enables the passive device to be encircled in the RDL structure, thereby enabling the RDL structure to form an effective protection for the passive device.

As one optional implementation, after the step of underfill and molding a gap and surrounding of the intermediate package member, further comprising:
thinning the encapsulation layer (e.g., molding material) to expose a backside of the chip to form a second intermediate package member;

In some embodiments, during underfill and molding the gap and surrounding of the first intermediate package member, the backfill material and the encapsulation layer (e.g., the molding material) typically cover (e.g., completely cover) the chip, and considering a heat sink of the chip, it is necessary to perform a removing process on the encapsulation layer (e.g., the molding material) until the backside of the chip is exposed (i.e., a surface of a side away from the RDL structure). For example, a flattening process (such as chemical mechanical polishing (CMP)) may be performed on the encapsulation layer to remove a portion of the encapsulation layer that is located on the side of the chip away from the RDL structure, i.e., to remove a portion of the encapsulation layer that covers the backside of the chip, thereby exposing the backside of the chip.

In some embodiments, a heat sink layer (e.g., a heat sink metal layer) may be disposed on the backside of the second intermediate package member. For example, the heat sink layer may be disposed along a surface of a side of the chip and the encapsulation layer away from the RDL structure.

In some embodiments, disposing a heat sink layer (e.g., a heat sink metal layer) on the backside of the intermediate package member, is enables to effectively export the heat of the chip outwardly, and as a preferred embodiment, the heat sink metal layer may be spread over the entire backside of the second intermediate package member so as to increase heat sink area.

As one optional implementation, after underfill and molding the gap and surrounding of the first intermediate package member, further comprising:
debonding the rigid carrier plate to the package substrate and removing residual bonding adhesive.

In some embodiments, after underfill and molding the gap and surrounding of the first intermediate package member, the fixation of the chip has been completed, at this time, the rigid carrier plate may be debonded with the package substrate to facilitate a subsequent installation of components such as heat sink covers.

As one optional implementation, after underfill and molding a gap and surrounding of the first intermediate package member, further comprising:
sawing the package substrate and the RDL structure to form a package monomer with a predetermined number of chips.

In some embodiments, in order to improve the efficiency and reliability of the packaging process, the package substrate and the RDL structure may be disposed to correspond to a board-level or wafer-level package substrate and a board-level or wafer-level RDL structure for multiple package monomers. The packaging for multiple package monomers can be completed in one packaging process. After the completion of packaging, a cut is performed to obtain a package monomer that can be matched with a component such as a heat dissipation member (e.g., a heat sink cover). In some other embodiments, the package substrate may also correspond to a single package monomer, and similarly, the RDL structure also corresponds to a single package monomer, in which case the package substrate and the RDL structure are cut after completing the underfill and molding, in order to make the package monomer and a component such as the heat sink member form a compatible shape. For example, the intermediate package member including the package substrate and the RDL structure and the chip and the like may include one or more package areas, and each package area corresponds to a package monomer, and each package monomer corresponds to a fan-out package structure. In embodiments where the intermediate package member comprises a plurality of package areas, the intermediate package member may be subjected to a sawing process to separate the plurality of package monomers to form a plurality of package monomers that are independent of each other (i.e., fan-out package structures). Each package structure has the structure described above with respect to FIG. 13 or FIG. 17.

As one optional implementation, further comprising: connecting the package monomer to a heat sink member (e.g., a heat sink cover), wherein a backside of the chip of the package monomer is in contact with the heat sink member (e.g., a heat sink cover) through a thermally conductive material.

In some embodiments, the heat sink material disposed on the backside of the chip of the package monomer may be a heat sink metal layer or other heat-conducting material, and the heat sink cover contacts the backside of the chip through the heat-conducting material, which is able to efficiently spread the heat generated by the chip outwardly, and, at the same time, is also able to form a protective effect on the chip.

As one optional implementation, the package substrate and the RDL structure have a plurality of package areas, and each of the package areas corresponds to a package monomer.

In some embodiments, the package areas disposed for the package substrate and the RDL structure facilitates the sawing of the package monomer after the completion of the subsequent packaging.

As one optional implementation, a top layer of the package substrate has an exposed metal layer.

As one optional implementation, the rigid carrier plate comprises a metal carrier plate or a glass carrier plate.

FIGS. 2 to 13 illustrate schematic diagrams of various steps in a manufacturing method of a fan-out package structure 1, according to some embodiments of the present disclosure, and a particular exemplary embodiment is provided below for an illustration of the technical solution provided by the present invention.

As shown in FIG. 2, a package substrate 101 required for fan-out packaging is prepared, the package substrate cancels a solder mask process in a top layer, a first conductive layer 102 (e.g., metal layer) on the outermost layer of the package substrate 101 is exposed in the top layer, and the entire package substrate is not cut and is made into a board-level or a wafer-level in accordance with the process requirements. As shown in FIG. 3, the package substrate is secured to a glass or metal carrier plate 201 by a temporary bonding adhesive so that a subsequent fan-out encapsulation process may better control the warpage. As shown in FIG. 4, an RDL process is performed on the top layer of the package substrate in accordance with the established fan-out design to form an RDL structure RS1 including at least one RDL layer 301.

Referring to FIGS. 4 and 13, in some embodiments, forming the RDL structure RS1 may comprise the following process. A first dielectric layer 30 is formed on the package substrate 101 (e.g., on a build-up layer B1) to cover the first conductive layer 102; the first dielectric layer 30 is formed on a side of the dielectric layer 11 of the build-up layer B1 away from the core layer 10, covering and being in contact with a portion of a surface of the dielectric layer 11, and covering and being in contact with a sidewall of the conductive layer 102 and a surface of a side thereof away from the core layer 10. Then, some portions of the first conductive layer 102 are removed, to form a plurality of openings in the first dielectric layer 30, a portion of the surface of the first dielectric layer 30 being exposed from the plurality of openings, respectively. Afterward, a first RDL layer 31 is formed on the first dielectric layer 30, and the first RDL layer 31 is filled in the openings of the first dielectric layer 30, to be in contact directly with and electrically connected to the first conductive layer 102 of the package substrate 101. For example, the first RDL layer 31 may comprise a conductive via 31V formed in the openings of the first dielectric layer and a conductive trace 31T formed on a side of the first dielectric layer away from the package substrate.

In some embodiments, the first dielectric layer 30 may comprise an organic dielectric material, an inorganic dielectric material, or a combination thereof; for example, the organic dielectric material may comprise a polymeric material such as polyimide, and the inorganic dielectric material may comprise silicon oxide and the like, and the present disclosure is not limited thereto. For example, the first dielectric layer may be formed by a suitable deposition process or spin coating process. In some embodiments, the first RDL layer 31 may include a seed layer and a metal layer and may be formed by a suitable process such as a deposition process (such as physical vapor deposition), a plating process (such as electroplating), a patterning process including etching and the like. In some embodiments, processes similar to those described above for forming the first dielectric layer and the first RDL layer may be repeated, to form an RDL structure including a plurality of dielectric layers and a plurality of RDL layers.

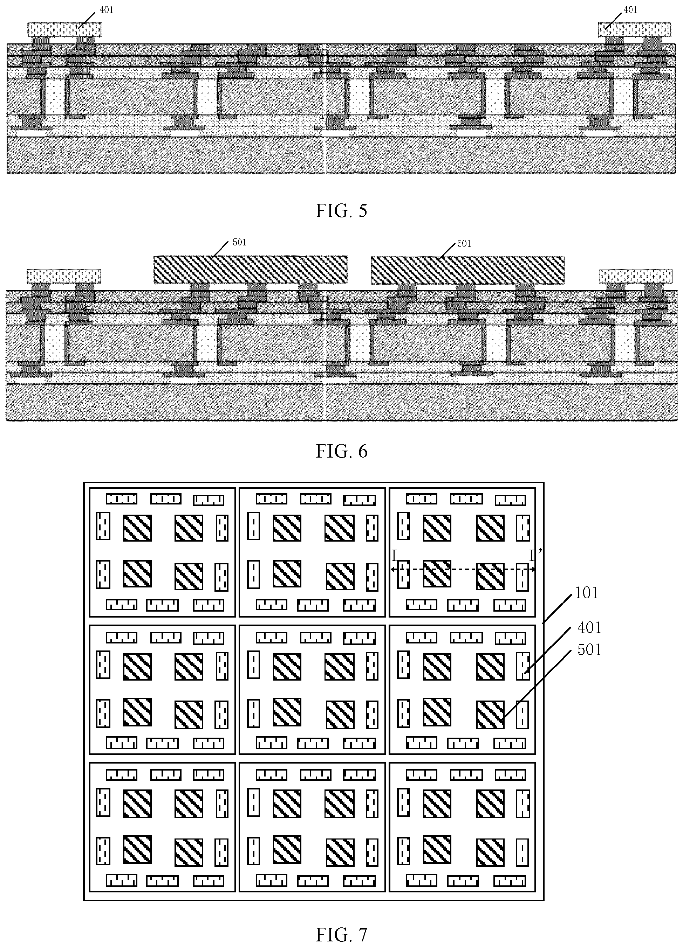

As shown in FIGS. 5 and 13, the passive device 401 is patched to the fan-out package body using a way of patching. For example, the passive device 401 may be engaged to a corresponding conductive pad in the RDL layer 33 of the RDL structure RS1 through a conductive connector 50b.

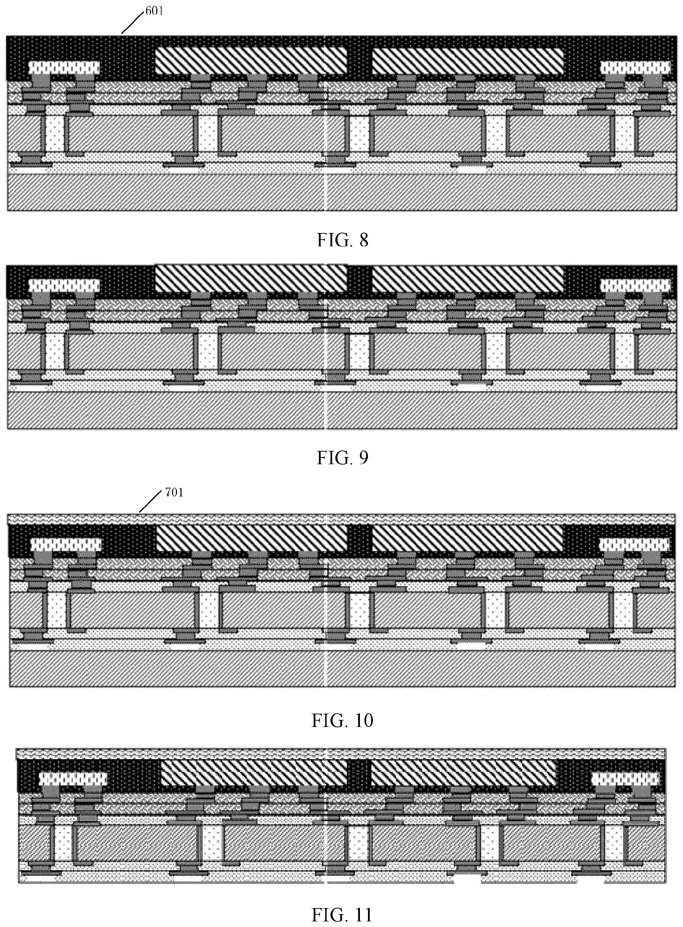

As shown in FIGS. 6 and 13, the chip 501 may be engaged to a corresponding conductive pad in the RDL layer 33 of the RDL structure RS1 through a conductive connector 50a; for example, the chip 501 is patched to the fan-out package body using a way of flip-flop soldering, and the conductive connector 50a may comprise a solder ball, but this disclosure is not limited thereto. After the above soldering action is completed, a top view of the whole fan-out package structure is shown in Figure 7. As shown in FIG. 7, the fan-out package structure body has a plurality of package areas, each of which is disposed with a chip and a passive device; the RDL structure and package substrate of the plurality of package areas are continuous, and conductive lines of the RDL structure and the package substrate located in the plurality of package areas are corresponding to and electrically connected with corresponding chips and passive devices, and the conductive lines located in the plurality of package areas are independent from each other. Those skilled in the art should be able to understand that FIG. 7 is only a schematic diagram, and the chip arrangement in each package area is not limited to 4, and the final product structure and arrangement of the quantity of positions are subject to the actual design. It should be noted that for the sake of graphical simplicity, FIGS. 2 to 6 and the subsequent FIGS. 8 to 17 only show a cross-sectional structure corresponding to one package area, for example, a cross-sectional view corresponding to the line I-I' intercept of FIG. 7. It should be understood that other package areas have similar structures.

As shown in FIGS. 8 and 13, after soldering the passive device as well as the chip to the fan-out package body, the entire package body is underfilled and molded at the board-level, and the passive device as well as the chip are molded and encircled at the bottom and surround the chip. In particular, an underfilling process is performed, to form an underfill layer 51 between chip 501 and the RDL structure RS1, and the underfill layer 51 may be formed between the passive device 401 and the RDL structure RS1; and an encapsulation process is performed to form an encapsulation layer 601 on a side of the RDL structure RS1 away from the package substrate. The encapsulation process may be or include a molding process, but the present disclosure is not limited thereto. In this step, the encapsulation layer 601 may completely enclose chip 501 and the passive device 401, e.g., it may cover sidewalls of the chip 501 and the passive device 401 and surfaces of the sides thereof away from the RDL structure, and may cover the sidewall of the underfill layer 51.

As shown in FIG. 9, after the completion of the board-level or wafer-level molding, the encapsulation layer (e.g., the molding material) 601 is thinned to leak out the chip, to facilitate proceeding subsequent processes. For example, a portion of the encapsulation layer 601 covering the backside of the chip may be removed by a flattening process.

As shown in FIG. 10, a heat sink layer 701 is formed on a side of the chip 501 away from the RDL structure; for example, the heat sink layer 701 may be a heat sink metal layer; for example, the entire piece of the fan-out package body may be backed by a gold process after the completion of the thinning process for the encapsulation layer, to form a heat sink metal layer, providing a heat sink for the subsequent packaging needs. As shown in FIG. 11, the glass carrier plate 201 is debonded and cleaned, and a temporary bonding adhesive is removed.

As shown in FIG. 12, a sawing process is performed on an intermediate package member, e.g., the intermediate package member may comprise a plurality of package areas and a sawing zone located between neighboring package areas, and the sawing process may be performed along the sawing zone such that a plurality of package monomers included in the intermediate package member are separated, and a plurality of package monomers (i.e., fan-out package structures) which are independent from each other are formed; for example, the sawing process may include a laser sawing or laser recessing process using a laser or a sawing process using a sawing knife or the like, and the like; in some embodiments, the sawing process singulating the fan-out package body after sawing the fan-out package body out of the heat sink cover fitment reserved area. As shown in FIG. 13, a heat sink member (e.g., a heat sink cover) 801 is patched to the fan-out package body after sawing into the singulation.

Referring to FIGS. 12 and 13, in some embodiments, the sawing process may comprise a first sawing process and a second sawing process; for example, the first sawing process is performed on at least the encapsulation layer and the RDL structure along a first sawing area, the first sawing process removes portions of the package substrate and the RDL structure and forms a recess between a plurality of package areas, a portion of the surface of the package substrate being exposed from the recess; for example, the second sawing process is performed on the exposed package substrate along a second sawing area; in some embodiments, a width of the second sawing area in a second direction parallel to a main surface of the package substrate may be less than a width of the first sawing area in the second direction, such that a stepped structure is provided at an edge of the formed package structure, i.e. the package substrate has an extension extending beyond the edge of the encapsulation layer and the RDL structure, thereby facilitating the installation of subsequent heat sink members.

For example, the first sawing process may cut through at least the encapsulation layer 601 and the RDL layer structure RS1 and may remove edge portions of the encapsulation layer 601 and the RDL structure RS1 disposed in each package area; in some embodiments, the first sawing process may also remove a portion of the dielectric layer of the build-up layer B1 of the package substrate 101 and may stop until the core layer 10 is exposed; in some other embodiments, the first sawing process may not remove the package substrate 101 and may stop as soon as a surface dielectric layer (e.g., dielectric layer 11) of the package substrate 101 is exposed. The second sawing process may cut through the package substrate 101. A width of the portion of the encapsulation layer and the RDL layer structure removed by the first sawing process may be greater than a width of the portion of the package substrate removed by the second sawing process such that in the package structure formed after completion of the sawing process, the package substrate has an extension extending beyond the edge of the encapsulation layer and the RDL layer structure to facilitate mounting of the heat dissipation member. For example, the first sawing process may include a laser recessing process, and the second sawing process may include a sawing process, but the present disclosure is not limited thereto.

In some embodiments, the sawing process removes a portion of the dielectric material in the RDL structure and the package substrate without removing the conductive members in the RDL structure and the package substrate, and such that, in the formed package structure, the conductive members in both the RDL structure and the package substrate are protected by the dielectric material covering and are not exposed at the sidewall of the package structure.

Another particular exemplary embodiment is provided below to illustrate the technical solutions provided by the present invention. For example, FIGS. 14 to 17 illustrate schematic cross-sectional views of a method of fabricating package structure 2 according to some other embodiments of the present disclosure. The manufacturing method for package structure 2 is similar to the aforementioned manufacturing method for package structure 1, with the differences being that a passive device may be engaged to the package substrate before the formation of the RDL structure, and that a dielectric layer of the subsequently formed RDL structure may cover the passive device. Other process steps of the method of manufacturing package structure 2 are similar to those described for the manufacturing method for package structure 1 in the preceding embodiment, and similar process steps will not be specifically described hereinafter.

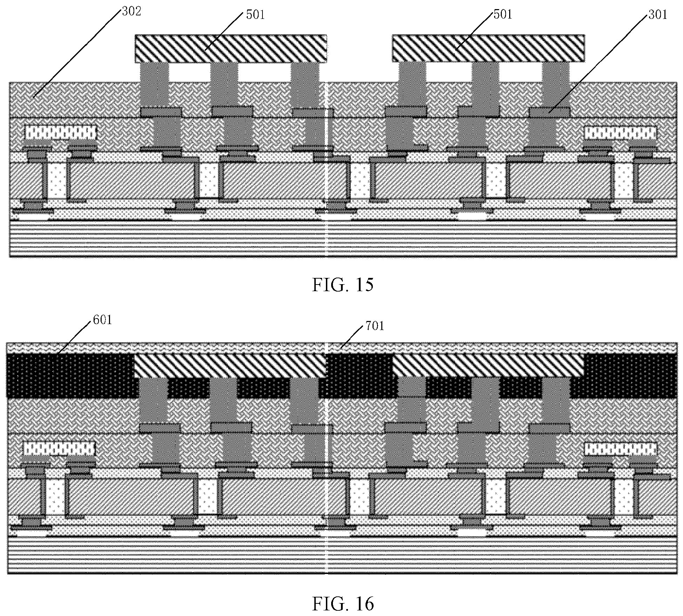

Referring to FIGS. 14 to 17, a package substrate 101 required for fan-out packaging is prepared, the package substrate cancels the solder mask process in a top layer, the outermost conductive layer (e.g., the first conductive layer 102) of the package substrate 101 is exposed in the top layer, and the first conductive layer 102 may be a metal layer, and the entire package substrate is not cut and is made into a board-level or a wafer-level in accordance with the process requirements. The package substrate is secured to the glass or metal carrier plate 201 by a temporary bonding adhesive so that the subsequent fan-out encapsulation process may better control the warpage. The passive device 401 is disposed on the package substrate to form a structure as shown in FIG. 14. An RDL structure RS2 comprising at least one RDL layer 301 and at least one dielectric layer 302 is then formed on the package substrate, at least one dielectric layer 302 may comprise a polymeric material such as polyimide, or may also comprise other types of dielectric materials, such as inorganic dielectric materials. At least one dielectric layer 302 (e.g., dielectric layer 30) will be covered by the passive device. The process for forming the RDL structure RS2 is similar to that described for the RDL structure RS1 in the previous embodiments and will not be repeated herein. The chip 501 is mounted on the RDL structure RS2, and the completed structure is shown in FIG. 15. The whole package body is then underfilled and molded at the board level or wafer level to form an underfill layer 51 and an encapsulation layer 601 to enclose the passive device and the bottom and surrounding of the chip in molding. After the completion of the board-level or wafer-level molding, the encapsulation layer 601 is thinned to leak out the chip, facilitating the subsequent process. After the completion, the whole piece of the fan-out package body to perform gold backing process, in order to form a heat sink layer 701, for the subsequent packaging to provide heat sink needs. After the completion the gold backing process, the structure is shown in FIG. 16. The glass carrier plate 201 is debonded and cleaned, and the temporary bonding adhesive is removed. After using a laser or a cutter to cut the fan-out package body out of the heat sink cover to fit the reserved area, singulating the fan-out package body. A heat dissipation member (e.g., a heat dissipation cover) 801 is patched to the fan-out package body after the singulation, the structure of which is shown in FIG. 17.

In embodiments of the present disclosure, the fan-out encapsulation process and the interconnection process between the package structure and the package substrate are integrated together to form the RDL structure directly on the package substrate, which may simplify the process and can realize the precise alignment of the package substrate and the RDL structure to ensure an effective electrical connection between them. Specifically, in conventional processes, a conventional package structure including an RDL structure is usually engaged to a package substrate by a soldering process, and during the packaging and/or soldering, if the package structure and/or the package substrate warps or shrinks, etc., the package substrate and the package structure cannot be aligned during soldering. In embodiments of the present disclosure, after the package substrate has been patched to the carrier plate, an RDL structure is formed directly on the package substrate, combining the fan-out encapsulation process and the substrate interconnection process, which can avoid problems such as the inability to be aligned during the soldering process of the conventional package structure and the package substrate, and can realize the precise alignment of the package substrate and the RDL structure and the effective electrical connection.

The foregoing is only particular implementations of the present invention, but the scope of protection of the present invention is not limited thereto, and any changes or substitutions that can be readily thought of by any person skilled in the art within the scope of the technology disclosed herein should be covered by the scope of protection of the present invention. Therefore, the scope of protection of the present invention should
be subject to the scope of protection of the claims.

## Claims

1. A fan-out package structure, comprising:
a package substrate (101), having a first side (101a) and a second side (101b) opposite to each other in a first direction (D1) and comprising a first conductive layer (102) disposed on the second side (101b);
an RDL structure (RS1, RS2), disposed on the second side (101b) of the package substrate (101), wherein the RDL structure (RS1, RS2) comprises at least one dielectric layer (302) and at least one RDL layer (301), the at least one RDL layer (301) embedded in the at least one dielectric layer (302) and electrically connected to the first conductive layer (102), the at least one dielectric layer (302) and the at least one RDL layer (301) comprise a first dielectric layer (30) and a first RDL layer (31), respectively, and wherein the first RDL layer (31) passes through the first dielectric layer (30), and be in contact with and electrically connected to the first conductive layer (102) of the package substrate (101);
a chip (501), disposed on a side of the RDL structure (RS1, RS2) away from the package substrate (101) and electrically connected to the at least one RDL layer (301) of the RDL structure (RS1, RS2); and
a second passive device (401), embedded in the at least one dielectric layer (302) of the RDL structure (RS1, RS2) and electrically connected to the first conductive layer (102) of the package substrate (101),
**characterized by**
before a formation of the RDL structures (RS1, RS2), the passive device (401) is engaged to the first conductive layer (102) of the package substrate (101) and the at least one dielectric layer (302) of the RDL structure (RS1, RS2) is further formed to cover the passive device (401).

2. The fan-out package structure of claim 1, wherein the first RDL layer (31) comprises a conductive via (31V) and a conductive trace (31T), the conductive via (31V) is located between the conductive trace (31T) and the first conductive layer (102), and electrically connects the conductive trace (31T) to the first conductive layer (102).

3. The fan-out package structure of claim 2, wherein the conductive via (31V) is embedded in the first dielectric layer (30), and the conductive trace (31T) is located on a side of the first dielectric layer (30) away from the package substrate (101).

4. The fan-out package structure of any of claims 1-3, wherein the first dielectric layer (30) also covers a sidewall of the first conductive layer (102) of the package substrate (101) and a portion of a surface of a side thereof close to the RDL structure (RS1, RS2).

5. The fan-out package structure of any of claims 1-4, wherein the package substrate (101) further comprises a second conductive layer (13) disposed on the first side (101a) and a solder mask (15), and the solder mask (15) covering a sidewall of the second conductive layer (13) and a portion of a surface of a side thereof away from the RDL structure (RS1, RS2).

6. The fan-out package structure of any of claims 1-5, further comprises:
an underfill layer (51), located between the chip (501) and the RDL structure (RS1, RS2) in the first direction (D1), wherein the chip (501) is electrically connected to the RDL structure (RS1, RS2) via an electrically conductive connector (50a, 50b), and the underfill layer (51) surrounds the electrically conductive connector (50a, 50b) in a direction parallel to a main surface of the package substrate (101).

7. The fan-out package structure of any of claims 1-6, further comprises:
an encapsulation layer (601), located on the side of the RDL structure (RS1, RS2) away from the package substrate (101), and surrounding and enclosing the chip (501) at least in a direction parallel to a main surface of the package substrate (101).

8. The fan-out package structure of any of claims 1-7, further comprises:
a first passive device (401), disposed on the side of the RDL structure (RS1, RS2) away from the package substrate (101) and electrically connected to the RDL structure (RS1, RS2), wherein the first passive device (401) and the chip (501) are disposed side-by-side in a direction parallel to a main surface of the package substrate (101).

9. The fan-out package structure of claim 8, wherein the first passive device (401) is enclosed by an encapsulation layer (601) located on the RDL structure (RS1, RS2).

10. The fan-out package structure of claim 7, wherein a sidewall of the encapsulation layer (601) and a sidewall of the RDL structure (RS1, RS2) are aligned in the first direction (D1) and the package substrate (101) has an extension (EP), and the extension (EP) protruding from the sidewall of the encapsulation layer (601) and the sidewall of the RDL structure (RS1, RS2) in a direction parallel to a main surface of the package substrate (101).

11. The fan-out package structure of claim 10, further comprises:
a heat sink member (801), disposed on the extension (EP) of the package substrate (101) and affixed to a surface of a side of the chip (501) away from the RDL structure (RS1, RS2).

12. The fan-out package structure of claim 11, further comprises:
a heat sink layer (701), disposed on the surface of the chip (501), and the heat sink member (801) is affixed to the surface of the chip (501) by the heat sink layer (701).

13. A manufacturing method of a fan-out package structure, comprising:
providing a package substrate (101), the package substrate (101) having a first side (101a) and a second side (101b) opposite to each other in a first direction (D1) and comprising a first conductive layer (102) disposed on the second side (101b);
forming an RDL structure (RS1, RS2) on the second side (101b) of the package substrate (101), wherein the RDL structure (RS1, RS2) comprises at least one dielectric layer (302) and at least one RDL layer (301), the at least one RDL layer (301) embedded in the at least one dielectric layer (302) and electrically connected to the first conductive layer (102), the at least one dielectric layer (302) and the at least one RDL layer (301) comprise a first dielectric layer (30) and a first RDL layer (31), respectively, and wherein the first RDL layer (31) passes through the first dielectric layer (30), and be in contact with and electrically connected to the first conductive layer (102) of the package substrate (101); and
engaging the chip (501) to the RDL structure (RS1, RS2) to form an intermediate package member, wherein the chip (501) is disposed on the side of the RDL structure (RS1, RS2) away from the package substrate (101) and electrically connected to the at least one RDL layer (301) of the RDL structure (RS1, RS2),
**characterized by** the manufacturing method further comprise:
before forming the RDL structures (RS1, RS2), engaging a passive device (401) to the first conductive layer (102) of the package substrate (101) and the at least one dielectric layer (302) of the RDL structure (RS1, RS2) is further formed to cover the passive device (401).

14. A fan-out packaging method, comprising:
bonding a first surface of a package substrate (101) to a rigid carrier plate;
electrically connecting a connection point on a first surface of an RDL structure (RS1, RS2) to a corresponding connection point on a second surface of the package substrate (101);
electrically connecting a pin of a chip (501) to be packaged to a corresponding connection point on a second surface of the RDL structure (RS1, RS2) to form a first intermediate package member; and
underfill and molding a gap and surrounding of the first intermediate package member,
**characterized by** the fan-out packaging method further comprise:
before the step of electrically connecting a connection point on a first surface of an RDL structure (RS1, RS2) to a corresponding connection point on a second surface of the package substrate (101), engaging a passive device (401) to a first conductive layer (102) of the package substrate (101) and at least one dielectric layer (302) of the RDL structure (RS1, RS2) is further formed to cover the passive device (401).

## Patentansprüche

1. Fan-Out-Verpackungsstruktur, umfassend:
ein Verpackungssubstrat (101), das eine erste Seite (101a) und eine zweite Seite (101b) aufweist, die einander in einer ersten Richtung (D1) gegenüberliegen, und eine erste leitfähige Schicht (102) umfasst, die auf der zweiten Seite (101b) angeordnet ist;
eine RDL-Struktur (RS1, RS2), die auf der zweiten Seite (101b) des Verpackungssubstrats (101) angeordnet ist, wobei die RDL-Struktur (RS1, RS2) mindestens eine dielektrische Schicht (302) und mindestens eine RDL-Schicht (301) umfasst, wobei die mindestens eine RDL-Schicht (301) in der mindestens einen dielektrischen Schicht (302) eingebettet und elektrisch mit der ersten leitfähigen Schicht (102) verbunden ist, wobei die mindestens eine dielektrische Schicht (302) und die mindestens eine RDL-Schicht (301) jeweils eine erste dielektrische Schicht (30) und eine erste RDL-Schicht (31) umfassen, und wobei die erste RDL-Schicht (31) durch die erste dielektrische Schicht (30) hindurchgeht und mit der ersten leitfähigen Schicht (102) des Verpackungssubstrats (101) in Kontakt steht und elektrisch mit dieser verbunden ist;
einen Chip (501), der auf einer Seite der RDL-Struktur (RS1, RS2) angeordnet ist, die vom Verpackungssubstrat (101) entfernt ist und elektrisch mit der mindestens einen RDL-Schicht (301) der RDL-Struktur (RS1, RS2) verbunden ist; und
eine zweite passive Vorrichtung (401), die in die mindestens eine dielektrische Schicht (302) der RDL-Struktur (RS1, RS2) eingebettet und elektrisch mit der ersten leitfähigen Schicht (102) des Verpackungssubstrats (101) verbunden ist,
wobei vor einer Bildung der RDL-Strukturen (RS1, RS2) die passive Vorrichtung (401) mit der ersten leitfähigen Schicht (102) des Verpackungssubstrats (101) in Eingriff gebracht wird und die mindestens eine dielektrische Schicht (302) der RDL-Struktur (RS1, RS2) weiter ausgebildet ist, um die passive Vorrichtung (401) zu bedecken.

2. Fan-Out-Verpackungsstruktur nach Anspruch 1, wobei die erste RDL-Schicht (31) ein leitfähiges Via (31V) und eine Leiterbahn (31T) umfasst, wobei sich das leitfähige Via (31V) zwischen der Leiterbahn (31T) und der ersten leitfähigen Schicht (102) befindet und die Leiterbahn (31T) elektrisch mit der ersten leitfähigen Schicht (102) verbindet.

3. Fan-Out-Verpackungsstruktur nach Anspruch 2, wobei das leitfähige Via (31V) in die erste dielektrische Schicht (30) eingebettet ist und sich das leitfähige Via (31T) auf einer Seite der ersten dielektrischen Schicht (30) entfernt vom Verpackungssubstrat (101) befindet.

4. Fan-Out-Verpackungsstruktur nach einem der Ansprüche 1-3, wobei die erste dielektrische Schicht (30) auch eine Seitenwand der ersten leitfähigen Schicht (102) des Verpackungssubstrats (101) und einen Abschnitt einer Oberfläche einer Seite davon, die der RDL-Struktur (RS1, RS2) nahe ist, bedeckt.

5. Fan-Out-Verpackungsstruktur nach einem der Ansprüche 1-4, wobei das Verpackungssubstrat (101) ferner eine zweite leitfähige Schicht (13) umfasst, die auf der ersten Seite (101a) angeordnet ist, sowie eine Lötstoppmaske (15), und die Lötstoppmaske (15) eine Seitenwand der zweiten leitfähigen Schicht (13) und einen Abschnitt einer Oberfläche einer Seite davon bedeckt, die von der RDL-Struktur (RS1, RS2) entfernt ist.

6. Fan-Out-Verpackungsstruktur nach einem der Ansprüche 1-5, ferner umfassend:
eine Unterfüllungsschicht (51), die sich zwischen dem Chip (501) und der RDL-Struktur (RS1, RS2) in der ersten Richtung (D1) befindet, wobei der Chip (501) elektrisch mit der RDL-Struktur (RS1, RS2) über einen elektrisch leitfähigen Steckverbinder (50a, 50b) verbunden ist, und die Unterfüllschicht (51) den elektrisch leitfähigen Steckverbinder (50a, 50b) in einer Richtung parallel zu einer Hauptfläche des Verpackungssubstrats (101) umgibt.

7. Fan-Out-Verpackungsstruktur nach einem der Ansprüche 1-6, ferner umfassend:
eine Einkapselungsschicht (601), die sich auf der vom Verpackungssubstrat (101) entfernten Seite der RDL-Struktur (RS1, RS2) befindet und den Chip (501) mindestens in einer Richtung parallel zu einer Hauptfläche des Verpackungssubstrats (101) umgibt und umschließt.

8. Fan-Out-Verpackungsstruktur nach einem der Ansprüche 1-7, ferner umfassend:
eine erste passive Vorrichtung (401), die auf der vom Verpackungssubstrat (101) entfernten Seite der RDL-Struktur (RS1, RS2) angeordnet und elektrisch mit der RDL-Struktur (RS1, RS2) verbunden ist, wobei die erste passive Vorrichtung (401) und der Chip (501) nebeneinander in einer Richtung parallel zu einer Hauptfläche des Verpackungssubstrats (101) angeordnet sind.

9. Fan-Out-Verpackungsstruktur nach Anspruch 8, wobei die erste passive Vorrichtung (401) von einer Einkapselungsschicht (601) umschlossen ist, die sich auf der RDL-Struktur (RS1, RS2) befindet.

10. Fan-Out-Verpackungsstruktur nach Anspruch 7, wobei eine Seitenwand der Einkapselungsschicht (601) und eine Seitenwand der RDL-Struktur (RS1, RS2) in der ersten Richtung (D1) ausgerichtet sind und das Verpackungssubstrat (101) eine Verlängerung (EP) aufweist, und die Verlängerung (EP) aus der Seitenwand der Einkapselungsschicht (601) und der Seitenwand der RDL-Struktur (RS1, RS2) in einer Richtung parallel zu einer Hauptfläche des Verpackungssubstrats (101) hervorsteht.

11. Fan-Out-Verpackungsstruktur nach Anspruch 10, ferner umfassend:
ein Kühlkörperelement (801), das auf der Verlängerung (EP) des Verpackungssubstrats (101) angeordnet und an einer von der RDL-Struktur (RS1, RS2) entfernten Oberfläche einer Seite des Chips (501) befestigt ist.

12. Fan-Out-Verpackungsstruktur nach Anspruch 11, ferner umfassend:
eine Kühlkörperschicht (701), die auf der Oberfläche des Chips (501) angeordnet ist, und das Kühlkörperelement (801) durch die Kühlkörperschicht (701) an der Oberfläche des Chips (501) befestigt ist.

13. Herstellungsverfahren einer Fan-Out-Verpackungsstruktur, umfassend:
Bereitstellen eines Verpackungssubstrats (101), wobei das Verpackungssubstrat (101) eine erste Seite (101a) und eine zweite Seite (101b) aufweist, die einander in einer ersten Richtung (D1) gegenüberliegen, und eine erste leitfähige Schicht (102) umfasst, die auf der zweiten Seite (101b) angeordnet ist;
Bilden einer RDL-Struktur (RS1, RS2) auf der zweiten Seite (101b) des Verpackungssubstrats (101), wobei die RDL-Struktur (RS1, RS2) mindestens eine dielektrische Schicht (302) und mindestens eine RDL-Schicht (301) umfasst, wobei die mindestens eine RDL-Schicht (301) in der mindestens einen dielektrischen Schicht (302) eingebettet und elektrisch mit der ersten leitfähigen Schicht (102) verbunden ist, wobei die mindestens eine dielektrische Schicht (302) und die mindestens eine RDL-Schicht (301) jeweils eine erste dielektrische Schicht (30) und eine erste RDL-Schicht (31) umfassen, und wobei die erste RDL-Schicht (31) durch die erste dielektrische Schicht (30) hindurchgeht und mit der ersten leitfähigen Schicht (102) des Verpackungssubstrats (101) in Kontakt steht und elektrisch mit dieser verbunden ist; und
Ineingriffbringen des Chips (501) mit der RDL-Struktur (RS1, RS2), um ein Zwischenverpackungselement zu bilden, wobei der Chip (501) auf der Seite der RDL-Struktur (RS1, RS2) angeordnet ist, die vom Verpackungssubstrat (101) entfernt ist, und elektrisch mit der mindestens einen RDL-Schicht (301) der RDL-Struktur (RS1, RS2) verbunden ist,
wobei das Herstellungsverfahren ferner umfasst:
vor dem Bilden der RDL-Strukturen (RS1, RS2), Ineingriffbringen einer passiven Vorrichtung (401) mit der ersten leitfähigen Schicht (102) des Verpackungssubstrats (101), und wobei die mindestens eine dielektrische Schicht (302) der RDL-Struktur (RS1, RS2) weiter ausgebildet wird, um die passive Vorrichtung (401) zu bedecken.

14. Fan-Out-Verpackungsverfahren, umfassend:
Verkleben einer ersten Oberfläche eines Verpackungssubstrats (101) mit einer starren Trägerplatte;
elektrisches Verbinden eines Verbindungspunkts auf einer ersten Oberfläche einer RDL-Struktur (RS1, RS2) mit einem entsprechenden Verbindungspunkt auf einer zweiten Oberfläche des Verpackungssubstrats (101);
elektrisches Verbinden eines Pins eines zu verpackenden Chips (501) mit einem entsprechenden Verbindungspunkt auf einer zweiten Oberfläche der RDL-Struktur (RS1, RS2), um ein erstes Zwischenverpackungselement zu bilden; und
Unterfüllen und Formen eines Spalts und der Umgebung des ersten Zwischenverpackungselements,
wobei das Fan-Out-Verpackungsverfahren ferner umfasst:
vor dem Schritt des elektrischen Verbindens eines Verbindungspunkts auf einer ersten Oberfläche einer RDL-Struktur (RS1, RS2) mit einem entsprechenden Verbindungspunkt auf einer zweiten Oberfläche des Verpackungssubstrats (101), Ineingriffbringen einer passiven Vorrichtung (401) mit einer ersten leitfähigen Schicht (102) des Verpackungssubstrats (101), und wobei mindestens eine dielektrische Schicht (302) der RDL-Struktur (RS1, RS2) weiter ausgebildet wird, um die passive Vorrichtung (401) zu bedecken.

## Revendications

1. Structure de boîtier à sortie en éventail, comprenant :
un substrat de boîtier (101), présentant une première face (101a) et une deuxième face (101b) opposées l'une à l'autre dans une première direction (D1) et comprenant une première couche conductrice (102) disposée sur la deuxième face (101b) ;
une structure RDL (RS1, RS2), disposée sur le deuxième côté (101b) du substrat de boîtier (101), dans laquelle la structure RDL (RS1, RS2) comprend au moins une couche diélectrique (302) et au moins une couche RDL (301), la au moins une couche RDL (301) étant noyée dans la au moins une couche diélectrique (302) et connectée électriquement à la première couche conductrice (102), la au moins une couche diélectrique (302) et la au moins une couche RDL (301) comprennent respectivement une première couche diélectrique (30) et une première couche RDL (31), et dans lequel la première couche RDL (31) traverse la première couche diélectrique (30), et est en contact avec la première couche conductrice (102) du substrat de boîtier (101) et connectée électriquement à celle-ci ;
une puce (501), disposée sur un côté de la structure RDL (RS1, RS2) opposé au substrat du boîtier (101) et reliée électriquement à la au moins une couche RDL (301) de la structure RDL (RS1, RS2) ; et
un deuxième dispositif passif (401), intégré dans la au moins une couche diélectrique (302) de la structure RDL (RS1, RS2) et connecté électriquement à la première couche conductrice (102) du substrat de boîtier (101),
**caractérisé en ce que**, avant la formation des structures RDL (RS1, RS2), le dispositif passif (401) est fixé à la première couche conductrice (102) du substrat de boîtier (101) et la au moins une couche diélectrique (302) de la structure RDL (RS1, RS2) est ensuite formée pour recouvrir le dispositif passif (401).

2. La structure de boîtier à sortie en éventail selon la revendication 1, dans laquelle la première couche RDL (31) comprend un trou d'interconnexion conducteur (31V) et une piste conductrice (31T), le trou d'interconnexion conducteur (31V) étant situé entre la piste conductrice (31T) et la première couche conductrice (102), et relie électriquement la piste conductrice (31T) à la première couche conductrice (102).

3. La structure de boîtier à sortie en éventail selon la revendication 2, dans laquelle le trou d'interconnexion conducteur (31V) est noyé dans la première couche diélectrique (30), et la piste conductrice (31T) est située sur un côté de la première couche diélectrique (30) opposé au substrat de boîtier (101).

4. La structure de boîtier à sortie en éventail selon l'une quelconque des revendications 1 à 3, dans laquelle la première couche diélectrique (30) recouvre également une paroi latérale de la première couche conductrice (102) du substrat de boîtier (101) et une partie d'une surface d'un côté de celui-ci proche de la structure RDL (RS1, RS2).

5. La structure de boîtier à sortie en éventail selon l'une quelconque des revendications 1 à 4, dans laquelle le substrat de boîtier (101) comprend en outre une deuxième couche conductrice (13) disposée sur la première face (101a) et un masque de soudure (15), et le masque de soudure (15) recouvrant une paroi latérale de la deuxième couche conductrice (13) et une partie d'une surface d'un côté de celle-ci éloigné de la structure RDL (RS1, RS2).

6. La structure de boîtier à sortie en éventail selon l'une quelconque des revendications 1 à 5, comprend en outre :
une couche de sous-remplissage (51), située entre la puce (501) et la structure RDL (RS1, RS2) dans la première direction (D1), dans laquelle la puce (501) est connectée électriquement à la structure RDL (RS1, RS2) via un connecteur électriquement conducteur (50a, 50b), et la couche de sous-remplissage (51) entoure le connecteur électriquement conducteur (50a, 50b) dans une direction parallèle à une surface principale du substrat de boîtier (101).

7. La structure de boîtier à sortie en éventail selon l'une quelconque des revendications 1 à 6, comprend en outre :
une couche d'encapsulation (601), située sur le côté de la structure RDL (RS1, RS2) opposé au substrat du boîtier (101), et entourant et renfermant la puce (501) au moins dans une direction parallèle à une surface principale du substrat du boîtier (101).

8. La structure de boîtier à sortie en éventail selon l'une quelconque des revendications 1 à 7, comprend en outre :
un premier dispositif passif (401), disposé sur le côté de la structure RDL (RS1, RS2) opposé au substrat de boîtier (101) et connecté électriquement à la structure RDL (RS1, RS2), dans laquelle le premier dispositif passif (401) et la puce (501) sont disposés côte à côte dans une direction parallèle à une surface principale du substrat de boîtier (101).

9. La structure de boîtier à sortie en éventail selon la revendication 8, dans laquelle le premier dispositif passif (401) est entouré par une couche d'encapsulation (601) située sur la structure RDL (RS1, RS2).

10. La structure de boîtier à sortie en éventail selon la revendication 7, dans laquelle une paroi latérale de la couche d'encapsulation (601) et une paroi latérale de la structure RDL (RS1, RS2) sont alignées dans la première direction (D1) et le substrat de boîtier (101) comporte une extension (EP), et l'extension (EP) fait saillie à partir de la paroi latérale de la couche d'encapsulation (601) et de la paroi latérale de la structure RDL (RS1, RS2) dans une direction parallèle à une surface principale du substrat de boîtier (101).

11. La structure de boîtier à sortie en éventail selon la revendication 10, comprend en outre :
un élément dissipateur de chaleur (801), disposé sur l'extension (EP) du substrat de boîtier (101) et fixé à une surface d'un côté de la puce (501) opposé à la structure RDL (RS1, RS2).

12. La structure de boîtier à sortie en éventail selon la revendication 11, comprend en outre :
une couche de dissipation thermique (701), disposée sur la surface de la puce (501), et l'élément de dissipation thermique (801) est fixé à la surface de la puce (501) par la couche de dissipation thermique (701).

13. Procédé de fabrication d'une structure de boîtier à sortie en éventail, comprenant :
la fourniture d'un substrat de boîtier (101), le substrat de boîtier (101) présentant une première face (101a) et une deuxième face (101b) opposées l'une à l'autre dans une première direction (D1) et comprenant une première couche conductrice (102) disposée sur la deuxième face (101b) ;
la formation d'une structure RDL (RS1, RS2) sur la deuxième face (101b) du substrat de boîtier (101), dans laquelle la structure RDL (RS1, RS2) comprend au moins une couche diélectrique (302) et au moins une couche RDL (301), la au moins une couche RDL (301) étant noyée dans la au moins une couche diélectrique (302) et connectée électriquement à la première couche conductrice (102), la au moins une couche diélectrique (302) et la au moins une couche RDL (301) comprenant respectivement une première couche diélectrique (30) et une première couche RDL (31), respectivement, et dans lequel la première couche RDL (31) traverse la première couche diélectrique (30) et est en contact avec la première couche conductrice (102) du substrat de boîtier (101) et connectée électriquement à celle-ci ; et
la fixation de la puce (501) à la structure RDL (RS1, RS2) pour former un élément de boîtier intermédiaire, la puce (501) étant disposée sur le côté de la structure RDL (RS1, RS2) opposé au substrat de boîtier (101) et connectée électriquement à la au moins une couche RDL (301) de la structure RDL (RS1, RS2),
**caractérisé en ce que** le procédé de fabrication comprend en outre :
avant de former les structures RDL (RS1, RS2), l'engagement d'un dispositif passif (401) sur la première couche conductrice (102) du substrat de boîtier (101), et la formation d'au moins une couche diélectrique (302) de la structure RDL (RS1, RS2) pour recouvrir le dispositif passif (401).

14. Procédé d'encapsulation à sortie en éventail, comprenant :
lier une première surface d'un substrat de boîtier (101) à une plaque de support rigide ;
connecter électriquement un point de connexion situé sur une première surface d'une structure RDL (RS1, RS2) à un point de connexion correspondant situé sur une deuxième surface du substrat de boîtier (101) ;
connecter électriquement une broche d'une puce (501) à encapsuler à un point de connexion correspondant situé sur une deuxième surface de la structure RDL (RS1, RS2) afin de former un premier élément d'encapsulation intermédiaire ; et
remplir et mouler un espace et la zone environnante du premier élément de boîtier intermédiaire,
**caractérisé en ce que** le procédé d'encapsulation à sortie en éventail comprend en outre :
avant l'étape consistant à connecter électriquement un point de connexion situé sur une première surface d'une structure RDL (RS1, RS2) à un point de connexion correspondant situé sur une deuxième surface du substrat de boîtier (101), l'engagement d'un dispositif passif (401) sur une première couche conductrice (102) du substrat de boîtier (101) et la formation d'au moins une couche diélectrique (302) de la structure RDL (RS1, RS2) pour recouvrir le dispositif passif (401).
